# EUROPÄISCHE PATENTSCHRIFT

(11) **EP 0 630 060 B1**
(45) Veröffentlichungstag und Bekanntmachung des Hinweises auf die Patenterteilung: **11.06.1997**
(21) Anmeldenummer: 94105654.1
(22) Anmeldetag: 13.04.1994
(51) Int. Cl.: H01L 39/14

(54) **Steuerbares Supraleiter-Bauelement**
Controllable superconducting device
Dispositif supra conducteur commandable

(30) Priorität: 21.06.1993 DE 4320484
(43) Veröffentlichungstag der Anmeldung: 21.12.1994
(73) Patentinhaber: DORNIER GmbH, D-88039 Friedrichshafen (DE)
(72) Erfinder: Downar, Hartmut, D-88682 Salem (DE); Peterreins, Thomas, Prof., D-93049 Regensburg (DE); Scherber, Werner, Dr., D-88697 Bermatingen (DE); Ziemann, Paul, Prof., D-78315 Radolfzell (DE)
(74) Vertreter: Landsmann, Ralf, Dipl.-Ing.

(56) Entgegenhaltungen:
- EP-A- 0 523 279
- EP-A- 0 533 519
- EP-A- 0 534 811

## Beschreibung

Die Erfindung betrifft ein mikroelektronisches Dünnfilm-Bauelement sowie ein Verfahren zur Steuerung der Impedanz einer supraleitenden Schicht.

Mit der Entdeckung der Hochtemperatur-Supraleiter (HTSL), welche noch bei Temperaturen oberhalb von 77 K (Siedepunkt von Stickstoff) eingesetzt werden können, sind neue Aussichten zur Realisierung von verlustarmen, schnellen elektronischen Schaltungen entstanden. Während die herkömmlichen Niedertemperatur-Supraleiter (NTSL) eine aufwendige Kühlung bis nahe am absoluten Nullpunkt erfordem und damit in der Anwendung sehr eingeschränkt sind, eröffnet der Betrieb bei Stickstofftemperaturen ein ungleich größeres Einsatzspektrum. Im übrigen werden auch andere hochwertige Bauelemente auf Basis von Halbleitern (HL), wie rauscharme Detektoren oder Höchstfrequenz-Schaltungen, in diesem Temperaturbereich betrieben, um ihre volle Leistungsfähigkeit nutzen zu können.

Aufgrund der besonderen Transportmechanismen bieten Supraleiter (SL) grundsätzlich für den Einsatz in elektronischen Schaltungen sehr interessante Vorteile: hohe Stromtragfähigkeit, kleinste Leiterquerschnitte, sehr niedrige Verlustleistungen bis hin zu höchsten Frequenzen, u.a. Andererseits steht dem Aufbau von Schaltungen auf Supraleiterbasis ein elementares Problem entgegen: aktive, steuerbare Elemente, sogenannte Trioden oder "Three Terminal Devices", entsprechend dem Halbleiter-Transistor, sind mit Supraleitem bislang nicht in konkurrenzfähiger Form realisierbar, so daß ihr Potential nur in beschränktem Umfang nutzbar ist. Zwar lassen sich aus SL hochwertige Einzelelemente wie Leiterbahnen, Induktivitäten, Resonatoren, Antennen etc. herstellen, diese müssen jedoch in einer relativ aufwendigen Hybridschaltung mit den aktiven HL-Elementen verbunden werden, so daß insgesamt kein überzeugender Vorteil entsteht.

Von den verschiedenen bekannten Hilfskonstruktionen, SL-Eigenschaften durch magnetische Felder, durch Temperatureinflüsse, durch Bestrahlung u.ä. zu steuern, sei hier abgesehen, da sie entweder zu langsam sind, keine positive Verstärkung zulassen, nicht miniaturisierbar sind oder aus sonstigen Gründen sich nicht als Elektronik-Komponente in Analogie zum Transistor verwenden lassen.

Solange der Einsatz der Supraleiter auf den Tiefsttemperaturbereich (NTSL) beschränkt war, ist dieses Manko aufgrund fehlender Anwendbarkeit nicht besonders in Erscheinung getreten. Mit der Verfügbarkeit der HTSL hat sich die Situation völlig verändert, zum einen, da jetzt erstmals der kombinierte Betrieb zusammen mit gekühlten Halbleiter-Schaltungen auf einem Temperaturniveau möglich ist und zum anderen, da weiterführend rein supraleitende Schaltungen mit solchen gekühlten HL-Schaltungen in Konkurrenz treten könnten. Bekanntlich sind seitdem zahlreiche Forschungsaktivitäten zur Entwicklung des "Supratransistors", des "Super-FET" oder ähnlicher Elemente angestoßen worden.

Die Schwierigkeiten, die sich der Realisierung aktiver Supra-Elemente entgegenstellen, sind wohlbekannt. Ein primäres Problem besteht darin, daß die in Halbleiterstrukturen genutzten Mechanismen auf Raumladungs- und Feldeffekten beruhen, welche bei Supraleitem grundsätzlich nicht in vergleichbarer Form auftreten; es müssen also völlig andere Steuermechanismen entwickelt und eingesetzt werden.

Ein zweites, gravierenderes Problem liegt in der Technologie der neuen Supraleiter. Sie bestehen aus oxidischen Substanzen mit komplexer Kristallstruktur (z.B. YBa₂Cu₃O₇) und erfordern spezielle Beschichtungsverfahren, welche bei hohen Temperaturen (bis 800 °C) und streng kontrollierten Umgebungsbedingungen ablaufen. Die Herstellungsbedingungen sind so kritisch, daß der Aufbau von Mehrlagenstrukturen, als Voraussetzung für integrierte Schaltungen, bis heute äußerst schwierig ist. Selbst das Übereinanderlegen von zwei perfekten SL-Schichten mit dazwischenliegender Isolatorschicht, z.B. für gewöhnliche Leiterbahnüberkreuzungen, bereitet erhebliche technologische Probleme und ist bislang nur in Einzelfällen und an kleinsten Flächen gelungen.

Die Aufgabe, die sich der Erfindung stellt, besteht demnach darin, ein elektronisches Bauelement auf Basis von Supraleitem, insbesondere HTSL, zu schaffen, das es erlaubt, mittels einer Steuerelektrode (Gate) den Stromfluß bzw. die Spannung zwischen den beiden anderen Elektroden direkt zu beeinflussen. Das neue Element soll sich hinsichtlich seiner Struktur, Größe und Herstellungstechnik als Komponente von integrierten Mikroelektronik-Schaltungen eignen und die bekannten Vorteile von Supraleitem (niedrige Impedanz, geringe Verluste, kleine Spannungspegel, dispersionsfreie Hochfrequenz-Übertragung etc.) mit der möglichen Funktion des Schaltens, des Steuems oder der Signalverstärkung verknüpfen.

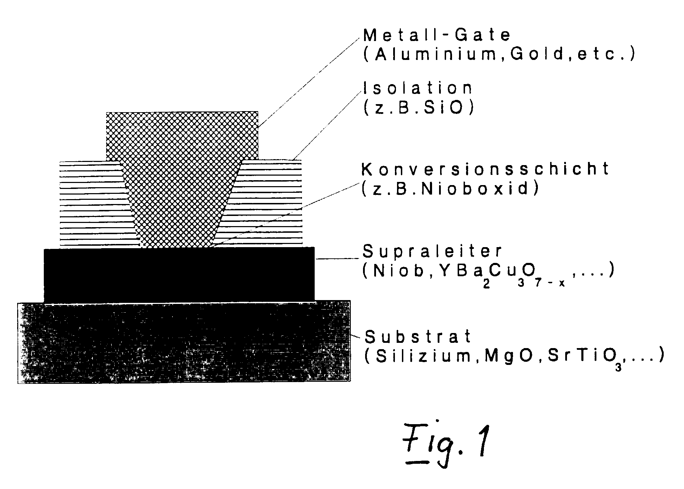

Diese Aufgabe wird erfindungsgemäß durch ein Dünnfilm-Bauelement nach Anspruch 1 gelöst. Sein prinzipieller Aufbau ist in Fig. 1 dargestellt. Auf einem geeigneten Substrat wird zunächst nach den bekannten Methoden eine SL-Schicht abgeschieden und strukturiert. Auf einem Teil der SL-Schicht wird eine spezielle, zunächst quasi-isolierende Schicht (Konversionsschicht) abgeschieden und darüber eine Metall-Elektrode (Gate) gelegt. Der beschriebene Schichtaufbau könnte demnach als MIS-Element (Metall-lsolator-Supraleiter) bezeichnet werden. Neu im Sinne der Erfindung ist es, durch Elektronentransfer über das Gate reversibel eine Veränderung der Leitfähigkeit um mehrere Größenordnungen in der sehr dünn ausgeführten Konversionsschicht hervorzurufen, wodurch die Transporteigenschaften in dem angrenzenden Supraleiter gesteuert werden können.

Vereinfacht ausgedrückt, findet ein Isolator-Metall-Übergang in der Konversionsschicht statt, für den verschiedene physikalische Mechanismen denkbar sind. Als ursächlich für die Steuerung der Eigenschaften des Supraleiters ist jedoch in jedem Fall die drastische Leitfähigkeitsänderung in der an den Supraleiter angrenzenden Konversionsschicht anzusehen. Im einfachsten Fall kann die Leitfähigkeit durch Tunneln von Elektronen in das Leitungsband der Konversionsschicht gesteuert werden, wobei zwischen Gate und Supraleiter eine Spannung von mehreren Volt, nahe an der Durchbruchspannung der Konversionsschicht, angelegt wird.

Für die Konversionsschicht besonders geeignet erscheinen Materialien, von denen bekannt ist, daß sie einen Isolator-Metall-Übergang in Form eines Phasenübergangs durchmachen¹. Beispiele für derartige Phasenübergänge finden sich u.a. bei Verbindungen der Übergangsmetalle, z.B. bei Oxiden des Vanadiums, des Wolframs, des Niobs, des Titans etc., sowie bei deren Mischoxiden. Äußeres Merkmal dieser Stoffe ist, daß durch Temperatureinfluß eine drastische Änderung der elektronischen Leitfähigkeit hervorgerufen werden kann. Oberhalb einer bestimmten Sprung- oder Übergangstemperatur ist in der Regel die metallische Phase mit guter Leitfähigkeit und bei tieferen Temperaturen eine isolierende oder halbleitende Phase mit wesentlich geringerer Leitfähigkeit existent. Der Phasenübergang kann die Folge einer gewöhnlichen Änderung der Kristallmodifikation sein, es ist jedoch auch möglich, daß er primär durch eine Veränderung der elektronischen Bandstruktur des Kristalls hervorgerufen wird, wobei die Gitterstruktur im wesentlichen erhalten bleibt. Als Beispiel sei der sogenannte Anderson-Übergang ² genannt, der durch Delokalisierung von Ladungsträgern zustande kommt. Die freigesetzten Ladungsträger bevölkern das Leitungsband und erzeugen eine starke Zunahme der Leitfähigkeit. Die Delokalisierung kann am einfachsten durch thermische Aktivierung hervorgerufen und beobachtet werden, ist aber grundsätzlich nicht darauf beschränkt. Für die Konversionsschicht im Sinne der Erfindung kommen aus dieser Stoffklasse ausschließlich Materialien mit elektronisch bedingtem Phasenübergang in Betracht.
¹ N.F.Mott, E.A.Davis: Electronic Processes in Non-Cristalline Materials; Clarendon Press Oxford (1971), S. 121 ff.
² P.W.Anderson, Phys. Rev. 111, 1029 (1958)

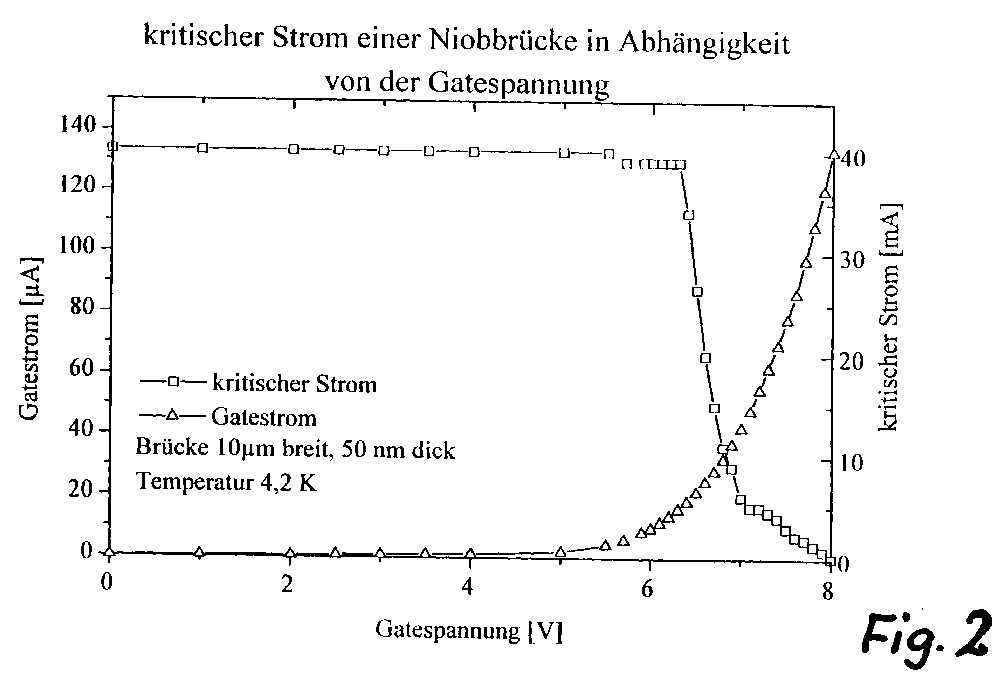

Es wurde experimentell nachgewiesen, daß der Stromfluß in der SL-Schicht durch eine Spannung am Gate sehr effektiv gesteuert werden kann. Die Figur 2 zeigt eine typische Kennlinie des Elementes. Man erkennt daraus, daß der kritische Strom der SL-Bahn von 40 mA durch ein Gatesignal vollständig unterdrückt wird, d.h. es findet ein kompletter Übergang vom supraleitenden Zustand in den normalleitenden Zustand statt. Der gleichzeitig über das Gate (Kontaktfläche 10 µm x 10 µm) fließende Steuerstrom liegt dabei um 100 µA, jedoch ist schon bei wenigen µA Gatestrom ein Einfluß auf die kritische Stromdichte im Supraleiter zu beobachten.

Beim Vergleich des erfindungsgemäßen Bauelementes mit aus der Literatur bekannten Systemen ist zunächst an Strukturen zu denken, bei denen in einem ähnlichen Schichtaufbau hochenergetische Quasiteilchen in den Supraleiter eingebracht werden, die dessen Transporteigenschaften verändern ^{3,4}. Die Kennlinien solcher Strukturen erscheinen zunächst qualitativ ähnlich zu denen des erfindungsgemäßen Bauelementes, doch sind dort zum Schalten des Supraleiters wesentlich höhere Ströme nötig, was auf dem unterschiedlichen Wirkungsmechanismus beruhen dürfte. Definiert man, wie in der Literatur üblich, einen Stromverstärkungsfaktor als Quotient (ggf. differentiell) aus geschaltetem kritischem Strom im Supraleiter zu injiziertem Gatestrom, so erreichen die in der Literatur beschriebenen Systeme Werte um 1 bis 10, während mit dem neuen Element Verstärkungsfaktoren nach dieser Definition von 100 bis 1000 erreicht wurden.
³ T. Kobayashi, K. Hashimoto, U. Kabasawa, M. Tonouchi: Three Terminal YBaCuO Josephson Device with Quasi-Particle Injection Gate; IEEE Transactions on Magnetics **25**, 927-930 (1989)
⁴ K.Takeuchi, Y.Okabe: Injection Controlled Superconducting Links; Jpn.J.Appl.Phys. **28**, 1810 - 1815 (1989)
⁵ J.Mannhart, J.G.Bednorz, K.A.Müller, D.G.Schlom: Electric Field Effect on Superconducting YBa₂Cu₃O_{7-δ} Films; Z.Phys. B - Condensed Matter **83**, 307 - 311 (1991)

Ähnliche Strukturen werden auch zur Untersuchung von Feldeffekten an SL-Schichten eingesetzt. IBM 5 berichtet von Strukturen mit etwa 160 nm Isolatordicke, welche mit Gatespannungen im Bereich von 30 Volt betrieben werden. Unter dem Einfluß dieser Feldstärke wird im Supraleiter eine Widerstandsänderung um 1% beobachtet. Obwohl in dieser Anordnung ein sehr geringer Gatestrom zu registrieren ist, hat er keinen Einfluß auf den Suprastrom und ist für den Steuermechanismus nicht relevant. Der Effekt ist größer, wenn an supraleitenden Weak Links gearbeitet wird. Nebenbei sei erwähnt, daß reine Feldeffekt-Elemente dieser Art auch von der Halbleitertechnik her bekannt sind und dort ebenfalls mit MIS (dort: metal-isolator-semiconductor) bezeichnet werden.

Eine nähere Untersuchung der Kennlinien des neuen MIS-Transistors zeigt deutlicher die Unterschiede zu schon bekannten Bauelementen auf. So ist aus der Figur 2 auch deutlich die Kopplung zwischen kritischem Strom und Injektorstrom zu erkennen, d.h. der SL/NL-Übergang setzt genau bei der Gatespannung ein, bei der auch der Elektronentransfer an der Gateelektrode beginnt. Bei Verwendung anderer Materialien für den Aufbau der Struktur mag die Schwellenspannung variieren - typischerweise in einem Bereich von 0,5 bis 7 Volt - , es bleibt jedoch stets der gezeigte Zusammenhang zwischen Injektorstrom und kritischem Strom erhalten. Daraus können eindeutig folgende Schlußfolgerungen gezogen werden:
- Das erfindungsgemäße Bauelement beruht nicht auf einem reinen Feldeffekt, es ist stets notwendigerweise ein Stromfluß am Gate, bzw. ein Injektionseffekt vorhanden.
- Andererseits ist der Effekt nicht durch die reine Stromeinleitung erklärbar. Wird nämlich bei der Herstellung des Elements die Isolatorschicht weggelassen und über das Gate ein Injektorstrom gleicher Größenordnung direkt in den Supraleiter eingeleitet, bleibt der dargestellte Schalteffekt völlig aus.
- Der Gatestrom, der für einen meßbaren Effekt im Supraleiter benötigt wird, ist so klein, daß die direkte Wirkung von hochenergetischen Quasiteilchen im Supraleiter zur Erklärung ausscheidet. Ähnliches gilt für thermische Effekte.

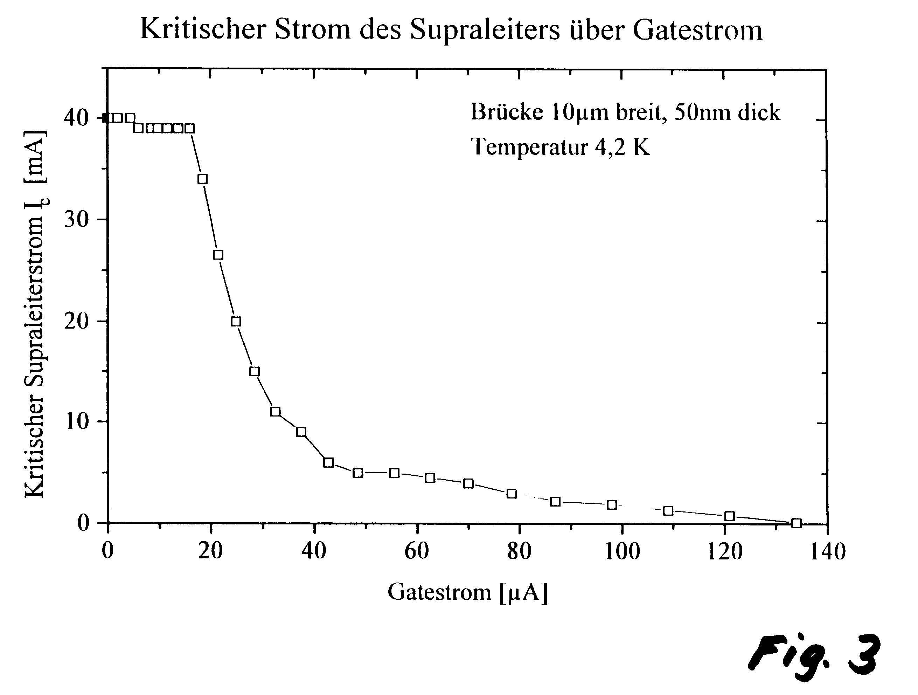

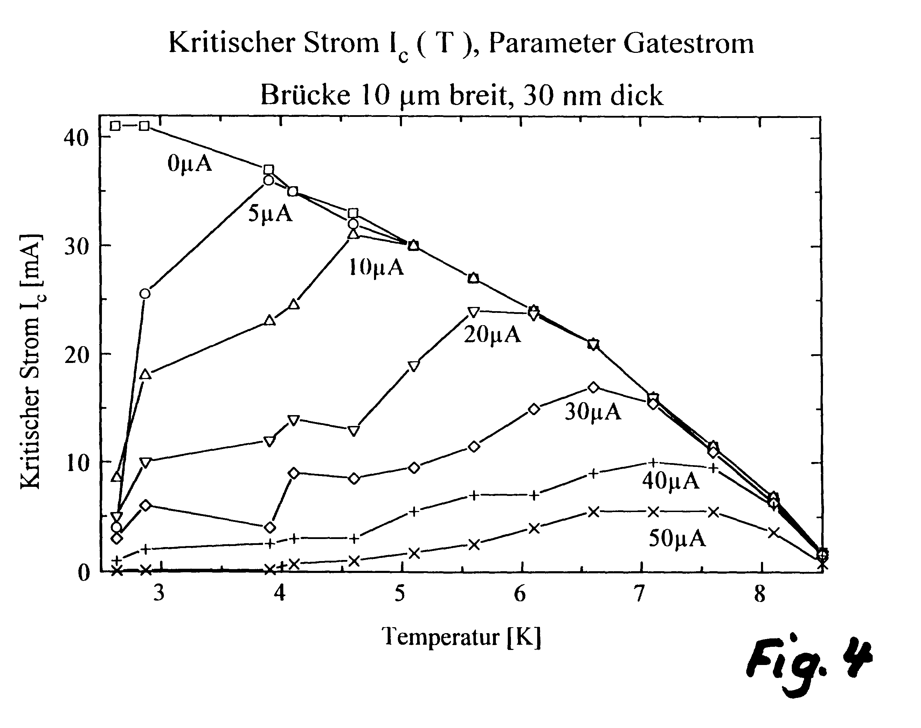

Der innere, physikalische Wirkungsmechanismus des neuen MIS-Elementes ist noch nicht in allen Einzelheiten geklärt. Die überzeugendste Interpretation sagt jedoch aus, daß der durch Aufnahme von Elektronen in der Isolatorschicht erzeugte Übergang in den metallischen Zustand einen Proximity-Effekt in der angrenzenden SL-Schicht bewirkt. Der Proximity-Effekt führt zu einer Reduzierung der Energielücke der supraleitenden Elektronen, was eine Erniedrigung der kritischen Übergangstemperatur zur Folge hat. Eine weitere Auswirkung des Übergangs in der Konversionsschicht könnte darin bestehen, daß der Supraleiter an der Kontaktfläche zur Änderung seiner Oberflächenenergie gezwungen wird, was eine Reduzierung der Pinningkraft zur Folge hat. Dies wiederum reduziert die maximale supraleitende Stromdichte. Wahrscheinlich sind sogar beide Effekte für den Steuereffekt verantwortlich; ein Hinweis darauf läßt sich beispielsweise aus der Figur 3 entnehmen (kritischer Strom als Funktion des Injektorstromes), in der zu erkennen ist, daß offensichtlich zwei Vorgänge mit unterschiedlicher Aktivierungsenergie beteiligt sind. Dagegen scheint die Elektroneneinleitung in den Supraleiter selbst keinen oder nur einen untergeordneten Einfluß auf den Steuervorgang zu haben. Weitere experimentelle Untersuchungen zur funktionalen Abhängigkeit des Schaltverhaltens, z.B. durch Variation der Temperatur (Figur 4), durch Verwendung verschiedener Materialien und Schichtdicken oder durch Anwendung eines äußeren Magnetfeldes wurden durchgeführt und bestätigen die gegebene Interpretation.

Das erfindungsgemäße Bauelement eignet sich grundsätzlich für jeden Supraleitertyp, allerdings müssen Konversionsschicht und Gateelektrode in der Wahl der Materialien sowie der entsprechenden Schichtdicken sorgfältig aufeinander abgestimmt werden. Die Schichtdicke der Konversionsschicht sollte vorteilhafterweise in der Größenordnung der freien Weglänge der Injektionselektronen liegen, also bei etwa 5 bis 20 nm, jedenfalls größer als die Schichtdicke von Tunnelbarrieren und kleiner als die Dicke hochohmiger Gateoxide. Die Schichtdicke des Supraleiters ist im Hinblick auf den Schalteffekt möglichst gering einzustellen und richtet sich im übrigen nach der geforderten Stromtragfähigkeit fähigkeit im supraleitenden und normalleitenden Zustand. Die zulässige maximale SL-Schichtdicke hängt, wie vom Proximity-Effekt her bekannt, hauptsächlich von der Kohärenzlänge ab. Typische Werte liegen je nach SL-Typ zwischen 1 und 100 nm. Im Experiment wurde bisher für den Supraleiter das Element Niob und für die Konversionsschicht Nioboxid NbOₓ verwendet. Letzteres sollte sich auch für andere NTSL wie Blei, Aluminium etc. eignen. Verwendet man für die Konversionsschicht Vertreter der oben erwähnten Material klasse mit einem Isolator-Metall-Phasenübergang, so ist zu beachten, daß die Übergangstemperatur oberhalb der Betriebstemperatur des Supraleiters liegen muß. Für HTSL wie YBa₂Cu₃O₇ sind daher beispielsweise Vanadiumoxid V₂O₃ (Übergang bei 150 K), NiS (250 K) oder Ti₂O₃ (>300 K) attraktiv.

Die elektronischen Eigenschaften des Elementes in Verbindung mit seinem einfachen Aufbau bieten sehr vorteilhafte Anwendungsmöglichkeiten. Zwar besteht ein Teil der Struktur - die Gateelektrode - aus normalleitendem Metall, jedoch können dessen Zuleitungen mit genügender Schichtdicke und mit kleinen Längen ausgeführt und die darin hervorgerufenen ohmschen Verluste vernachlässigbar klein gehalten werden. Für NTSL-Schaltungen kann die Gateelektrode ebenfalls aus supraleitendem Material bestehen, so daß eine SIS-Struktur entsteht. Im Hinblick auf HTSL-Schaltungen ist die MIS-Struktur sehr vorteilhaft, da sie die oben erwähnten technologischen Probleme der Herstellung von supraleitenden Multilagen umgeht.

Anwendungen des neuen Bauelementes liegen zunächst überall dort, wo es als Substitut für Halbleiter-Transistoren eingesetzt werden kann, so in Hybridschaltungen aus Supraleitem und Halbleitem, die z.B. bei 77 K betrieben werden, oder in rein supraleitenden elektronischen Schaltungen mit Betrieb ggf. auch bei Heliumtemperatur (4,2 K). Die konkrete Beschaltung ist dabei natürlich dem Kennlinienfeld des neuen Elementes so anzupassen, daß seine Schalt-, Steuer- und Verstärkungsfunktion optimal genutzt werden kann.

Betrachtet man die Kennlinie in Figur 3, so wird deutlich, daß daneben auch die dosierte Veränderung der Transporteigenschaften des supraleitenden Streifens für spezielle Anwendungen interessant werden kann. Hier ist besonders an Hochfrequenz-Bauelemente zu denken, bei denen die vorteilhaften HF-Eigenschaften der Supraleiter genutzt werden. So könnte bei einem bereits demonstrierten supraleitenden Bauelement wie einem Hochfrequenz-Resonator die Güte durch Beeinflussung eines Teils der Leiterbahn gesteuert werden. Andere, weiterführende Ansätze betreffen auch neuartige supraleitende HF-Bauelemente wie z.B. einen Phasenschieber, dessen Funktion auf der Änderung der kinetischen Induktivität eines Leiterstücks beruht, oder einen Oszillator mit dem neuen MIS-Element in der Rückkoppelschleife.

Soweit heute erkennbar, liegen Anwendungen der Erfindung hauptsächlich in der Mikroelektronik, Kommunikationselektronik, Mikrowellentechnik und Datenverarbeitung.

## Patentansprüche

1. Mikroelektronisches Dünnfilm-Bauelement, mit einer Konversionsschicht, die auf einer ihrer Flachseiten zu einer supraleitenden Schicht und auf ihrer anderen Flachseite zu einer normalleitenden oder supraleitenden Gateelektrode unmittelbaren Kontakt aufweist, wobei die Kennlinie der Leitfähigkeit der Konversionsschicht eine sprungartige Erhöhung um mindestens zwei Zehnerpotenzen aufweist, und die Leitfähigkeitserhöhung mittels eines elektrischen Feldes zwischen Gateelektrode und supraleitender Schicht steuerbar ist, und die Impedanz der supraleitenden Schicht durch die Leitfähigkeitsänderung steuerbar ist und die Leitfähigkeitsänderung reversibel ist.

2. Bauelement nach Anspruch 1, dadurch gekennzeichnet, daß die Leitfähigkeit der Konversionsschicht durch eine Temperaturänderung steuerbar ist.

3. Bauelement nach Anspruch 1 oder 2, dadurch gekennzeichnet, daß die Konversionsschicht eine Schichtdicke im Bereich der elektronischen freien Weglänge in der Konversionsschicht im Zustand der erhöhten Leitfähigkeit, bevorzugt im Bereich von 5-20 nm aufweist.

4. Bauelement nach einem der Ansprüche 1 bis 3, dadurch gekennzeichnet, daß die supraleitende Schicht eine Schichtdicke im Bereich der Größenordnung ihrer Kohärenzlänge aufweist.

5. Bauelement nach einem der Ansprüche 1 bis 4, dadurch gekennzeichnet, daß die supraleitende Schicht eine Schichtdicke im Bereich zwischen 1 und 100 nm aufweist.

6. Bauelement nach nach einem der Ansprüche 1 bis 5, dadurch gekennzeichnet, daß das Bauelement ein Verhältnis aus geschaltetem kritischen Strom in der supraleitenden Schicht zu aus dem elektrischen Feld folgenden Steuerstrom in die Konversionsschicht zwischen 100 und 1000 aufweist.

7. Bauelement nach nach einem der Ansprüche 1 bis 6, dadurch gekennzeichnet, daß die supraleitende Schicht aus einem metallischen Supraleiter wie Niob, Blei, Aluminium oder einem keramischen Supraleiter wie YBaCuO gebildet ist.

8. Bauelement nach nach einem der Ansprüche 1 bis 7, dadurch gekennzeichnet, daß die Konversionsschicht aus einem Material aus der Gruppe von Nioboxid, Vanadiumoxid, Nickelsulfid, Titanoxid gebildet ist.

9. Verfahren zur Steuerung der Impedanz einer supraleitenden Schicht, wobei eine Konversionsschicht, die auf einer ihrer Flachseiten zu der supraleitenden Schicht und auf ihrer anderen Flachseite zu einer normalleitenden oder supraleitenden Gateelektrode unmittelbaren Kontakt aufweist, vorhanden ist, und die Kennlinie der Leitfähigkeit der Konversionsschicht eine sprungartige Erhöhung um mindestens zwei Zehnerpotenzen aufweist, wobei die Leitfähigkeitserhöhung mittels eines elektrischen Feldes zwischen Gateelektrode und supraleitender Schicht gesteuert wird, und durch diese Leitfähigkeitsänderung die Impedanz der supraleitenden Schicht gesteuert wird, wobei die Leitfähigkeitsänderung reversibel ist.

10. Verfahren nach Anspruch 9, dadurch gekennzeichnet, daß die Leitfähigkeitsänderung der Konversionsschicht durch eine Temperaturänderung verursacht wird.

11. Verfahren nach Anspruch 9 oder 10, dadurch gekennzeichnet, daß die supraleitende Schicht aus einem metallischen Supraleiter wie Niob, Blei, Aluminium oder einem keramischen Supraleiter wie YBaCuO gebildet wird.

12. Verfahren nach nach einem der Ansprüche 9 bis 11, dadurch gekennzeichnet, daß die Dicke der supraleitenden Schicht im Bereich der Größenordnung ihrer Kohärenzlänge, insbesondere zwischen 1 und 100 nm, gewählt wird.

13. Verfahren nach nach einem der Ansprüche 9 bis 12, dadurch gekennzeichnet, daß für die Konversionsschicht eine Schichtdicke im Bereich der elektronischen freien Weglänge in der Konversionsschicht im Zustand der erhöhten Leitfähigkeit, bevorzugt im Bereich von 5-20 nm, gewählt wird.

14. Verfahren nach nach einem der Ansprüche 9 bis 13, dadurch gekennzeichnet, daß der kritische Strom der supraleitenden Schicht durch einen Stromfluß durch die Konversionsschicht oberhalb einer Schwellspannung zwischen supraleitenden Schicht und Gateelektrode moduliert wird.

15. Kryoelektronische Schaltung auf der Basis von Supraleitern, Halbleitern oder Supraleiter/Halbleiter-Hybridmodulen, dadurch gekennzeichnet, daß das aktive steuerbare Element ein mikroelektronisches Bauelement gemäß einem der Patentansprüche 1 bis 8 ist.

16. Verwendung eines mikroelektronischen Dünnfilm-Bauelements nach einem der Ansprüche 1 bis 8, dadurch gekennzeichnet, daß das Bauelement als Schalter und/oder als Verstärker eingesetzt wird.

## Claims

1. Microelectronic thin-film component with a conversion layer which has direct contact on one of its large faces with a superconductive layer and on its other large face with a normally conductive or superconductive gate electrode, in which the characteristic curve of the conductivity of the conversion layer has a sudden increase by at least two powers of ten, and the increase in conductivity is controllable by means of an electric field between the gate electrode and the superconductive layer, and the impedance of the superconductive layer is controllable by means of the change in conductivity, and the change in conductivity is reversible.

2. Component according to claim 1, characterized in that the conductivity of the conversion layer is controllable by means of a change in temperature.

3. Component according to claim 1 or claim 2, characterized in that the conversion layer has a layer thickness in the range of the electron free path length in the conversion layer in the increased conductivity condition, preferably in the range of 5-20 nm.

4. Component according to any one of claims 1 to 3, characterized in that the superconductive layer has a layer thickness in the region of the order of magnitude of its coherence length.

5. Component according to any one of claims 1 to 4, characterized in that the superconductive layer has a layer thickness in the range between 1 and 100 nm.

6. Component according to any one of claims 1 to 5, characterized in that the component has a ratio of switched critical current in the superconductive layer to control current resulting from the electric field in the conversion layer between 100 and 1000.

7. Component according to any one of claims 1 to 6, characterized in that the superconductive layer is formed from a metallic superconductor such as niobium, lead, aluminium or a ceramic superconductor such as YBaCuO.

8. Component according to any one of claims 1 to 7, characterized in that the conversion layer is formed from a material from the group of niobium oxide, vanadium oxide, nickel sulphide, titanium oxide.

9. Method of controlling the impedance of a superconductive layer, a conversion layer being present and having direct contact on one of its large faces with the superconductive layer and on its other large face with a normally conductive or superconductive gate electrode, and the characteristic curve of the conductivity of the conversion layer having a sudden increase by at least two powers of ten, the conductivity increase being controlled by means of an electric field between the gate electrode and the superconductive layer, and the impedance of the superconductive layer being controlled by means of this change in conductivity, the change in conductivity being reversible.

10. Method according to claim 9, characterized in that the change in conductivity of the conversion layer is brought about by a change in temperature.

11. Method according to claim 9 or claim 10, characterized in that the superconductive layer is formed from a metallic superconductor such as niobium, lead, aluminium or a ceramic superconductor such as YBaCuO.

12. Method according to any one of claims 9 to 11, characterized in that the thickness of the superconductive layer is selected in the region of the order of magnitude of its coherence length, particularly between 1 and 100 nm.

13. Method according to any one of claims 9 to 12, characterized in that, for the conversion layer, a layer thickness in the region of the electron free path length in the conversion layer in the increased conductivity condition, preferably in the range of 5-20 nm, is selected.

14. Method according to any one of Claims 9 to 13, characterized in that the critical current of the superconductive layer is modulated by a current flow through the conversion layer above a threshold voltage between the superconductive layer and the gate electrode.

15. Cryoelectronic circuit based on superconductors, semiconductors or superconductor/semiconductor hybrid modules, characterized in that the active, controllable element is a microelectronic component according to one of claims 1 to 8.

16. Use of a microelectronic thin-film component according to one of claims 1 to 8, characterized in that the component is used as a switch and/or as an amplifier.

## Revendications

1. Composant micro-électronique à couche mince, comprenant une couche de conversion qui est en contact direct avec une couche supraconductrice sur l'un de ses côtés plats et avec une grille à conduction normale ou supraconductrice sur son autre côté plat, **caractérisé en ce** que la courbe caractéristique de la conductibilité de la couche de conversion présente une augmentation brusque d'au moins deux puissances de dix, que l'augmentation de la conductibilité peut être commandée au moyen d'un champ électrique entre la grille et la couche supraconductrice, que l'impédance de la couche supraconductrice peut être commandée par la variation de la conductibilité, et que la conductibilité est réversible.

2. Composant selon la revendication 1, caractérisé en ce que la conductibilité de la couche de conversion peut être commandée par une variation de température.

3. Composant selon la revendication 1 ou 2, caractérisé en ce que la couche de conversion présente une épaisseur de couche dans la plage du parcours électronique libre à l'intérieur de la couche de conversion, à l'état de la conductibilité accrue, de préférence dans la plage de 5 à 20 nm.

4. Composant selon l'une des revendications 1 à 3, caractérisé en ce que la couche supraconductrice présente une épaisseur de couche dans la plage qui est de l'ordre de grandeur de sa longueur de cohérence.

5. Composant selon l'une des revendications 1 à 4, caractérisé en ce que la couche supraconductrice présente une épaisseur de couche comprise entre 1 et 100 nm.

6. Composant selon l'une des revendications 1 à 5, caractérisé en ce qu'il présente un rapport entre le courant critique commuté dans la couche supraconductrice et le courant de commande résultant du champ électrique dans la couche de conversion compris entre 100 et 1000.

7. Composant selon l'une des revendications 1 à 6, caractérisé en ce que la couche supraconductrice est constituée par un supraconducteur métallique tel que le niobium, le plomb, l'aluminium, ou par un supraconducteur céramique tel que du YBaCuO.

8. Composant selon l'une des revendications 1 à 7, caractérisé en ce que la couche de conversion est constituée par un matériau appartenant au groupe oxyde de niobium, oxyde de vanadium, sulfure de nickel, oxyde de titane.

9. Procédé pour la commande de l'impédance d'une couche supraconductrice, caractérisé en ce qu'il est prévu une couche de conversion qui est en contact direct avec la couche supraconductrice sur l'un de ses côtés plats et avec une grille à conduction normale ou supraconductrice sur son autre côté plat, et que la courbe caractéristique de la conductibilité de la couche de conversion présente une augmentation brusque d'au moins deux puissances de dix, l'augmentation de la conductibilité étant commandée au moyen d'un champ électrique entre la grille et la couche supraconductrice, ladite variation de la conductibilité commandant l'impédance de la couche supraconductrice, et la variation de la conductibilité étant réversible.

10. Procédé selon la revendication 9, caractérisé en ce que la variation de la conductibilité de la couche de conversion est provoquée par une variation de température.

11. Procédé selon la revendication 9 ou 10, caractérisé en ce que la couche supraconductrice est constituée par un supraconducteur métallique tel que le niobium, le plomb, l'aluminium, ou par un supraconducteur céramique tels du YBaCuO.

12. Procédé selon l'une des revendications 9 à 11, caractérisé en ce que l'épaisseur de la couche supraconductrice est choisie dans la plage de l'ordre de sa longueur de cohérence, notamment entre 1 et 100 nm.

13. Procédé selon l'une des revendications 9 à 12, caractérisé en ce que pour la couche de conversion, l'épaisseur de couche est choisie dans la plage du parcours électronique libre dans la couche de conversion, à l'état de la conductibilité accrue, de préférence dans la plage de 5 à 20 nm.

14. Procédé selon l'une des revendications 9 à 13, caractérisé en ce que le courant critique de la couche supraconductrice est modulé par une conduction de courant par la couche de conversion au-dessus d'une tension de seuil entre la couche supraconductrice et la grille.

15. Circuit cryoélectronique à base de supraconducteurs, de semi-conducteurs ou de modules hybrides de supraconducteur/semiconducteur, caractérisé en ce que le composant actif commandable est un composant micro-électronique selon l'une des revendications 1 à 8.

16. Utilisation d'un composant micro-électronique à couche mince selon l'une des revendications 1 à 8, caractérisée en ce que le composant est utilisé comme commutateur et/ou comme amplificateur.
